# EUROPEAN PATENT APPLICATION

(11) **EP 4 531 090 A1**
(43) Date of publication of application: **02.04.2025**
(21) Application number: 24197051.6
(22) Date of filing: 28.08.2024
(51) Int. Cl.: H01L 23/00

(54) **IC ASSEMBLIES WITH METAL PASSIVATION AT BOND INTERFACES**

(30) Priority: 28.09.2023 US 202318374573
(71) Applicant: Intel Corporation, Santa Clara, CA 95054 (US)
(72) Inventor: JUN, Kimin, Portland, 97229 (US); EID, Feras, Chandler, 85226 (US); ELSHERBINI, Adel, Chandler, 85248 (US); STRONG, Veronica, 1040 Etterbeek, Brussels (BE); SOUNART, Thomas, Chandler, 85226 (US)
(74) Representative: 2SPL Patentanwälte PartG mbB

(57) **Abstract**

A surface finish on an integrated circuit (IC) die structure or a substrate structure to which an IC die structure is to be bonded has a chemical composition distinct from that of underlying metallization. The surface finish may comprise a Cu-Ni alloy. Optionally, the Cu-Ni alloy may further comprise Mn. Alternatively, the surface finish may comprise a noble metal, such as Pd, Pt, or Ru or may comprise self-assembled monolayer (SAM) molecules comprising Si and C. During the bonding process a biphilic surface on the IC die structure or substrate structure may facilitate liquid droplet-based fine alignment of the IC die structure to a host structure. Prior to bonding, the surface finish may be applied upon a top surface of metallization features and may inhibit oxidation of the top surface exposed to the liquid droplet.

## Description

### BACKGROUND

Integrated circuit (IC) die can be assembled with solder attachment techniques where solder features are brought into contact to join dies to a host or base substrate. However, solder assembly techniques are difficult to scale below solder-bonded feature pitches that are in the tens of microns (e.g., 10-25 µm).

IC die may instead be assembled with hybrid bonding techniques where metallic bond sites of an IC die are directly interdiffused with corresponding metallic bond sites of a host or base substrate. Such bonding is referred to as "hybrid" where a bond also forms between dielectric materials adjacent to the metallic bond sites. During a hybrid bonding process, components (e.g., dies) having corresponding bond site structures, are brought together to interface with one another. At room temperature, dielectric material adheres sufficiently to establish an initial bond (e.g., due to Van der Waals forces). A thermal anneal may then fuse complementary metallic bond sites, and also increase the strength of the dielectric material bond interface. Hybrid bonding techniques are scalable well below bonded feature pitches of 1 µm. However, such nanometer pitch assembly techniques rely on nanometer scale (e.g., < 500 nm) fine alignment of IC die to the base substrate, which can be time consuming and/or expensive to implement.

Techniques and architectures for hybrid bonding at nanometer scales in high volume manufacturing are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements. Further, where considered appropriate, reference labels have been repeated among the figures to indicate corresponding or analogous elements. In the figures:
FIG. 1 is a flow diagram illustrating self-alignment assisted assembly (SA3) methods for integrated circuit (IC) die structures, in accordance with some embodiments;
FIG. 2A is a cross-sectional view of an interfacial layer upon a host structure, in accordance with some embodiments;
FIG. 2B is a plan view of the host structure illustrated in FIG. 2A, in accordance with some embodiments;
FIG. 3A is a cross-sectional view of a host structure with metal bonding site features including a surface finish, in accordance with some embodiments;
FIG. 3B is a plan view of the host structure illustrated in FIG. 3A, in accordance with some embodiments;
FIG. 4A is a cross-sectional view of alignment features defined into the host structure, in accordance with some embodiments;
FIG. 4B is a plan view of the host structure illustrated in FIG. 4A, in accordance with some embodiments;
FIG. 5A is a cross-sectional view of hydrophobic features formed on a host structure, in accordance with some embodiments;
FIG. 5B is a plan view of the host structure illustrated in FIG. 5A, in accordance with some embodiments;
FIG. 6A is a cross-sectional view of a wafer or panel comprising a plurality of host structures, each host structure comprising a biphilic surface structure, in accordance with some embodiments;
FIG. 6B is a plan view of the wafer or panel illustrated in FIG. 6A, in accordance with some embodiments;
FIG. 7A is a cross-sectional view of IC die structures being coarse aligned and placed on liquid droplets confined in bonding regions, in accordance with some embodiments;
FIG. 7B is a plan view of aligning and placing the IC die structures of FIG. 7A, in accordance with some embodiments;
FIG. 8 is a cross-sectional view of a composite structure comprising IC die structures hybrid bonded to bonding regions of biphilic structures of a host structure, in accordance with some embodiments;
FIG. 9 is a cross-sectional view of a composite structure comprising IC die structures and a dielectric material therebetween, in accordance with some embodiments;
FIG. 10 is a cross-sectional view of system comprising a heat sink and a host component assembled with a hybrid bonded composite structure further comprising an IC die structure, in accordance with some embodiments;
FIG. 11 illustrates a mobile computing platform and a data server machine employing a multi-chip package, in accordance with some embodiments; and
FIG. 12 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of' or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). As another example, a composition that is predominantly a first and second constituent more than half of the composition is the first and second constituents (e.g., <50 at. %).The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As previously noted, hybrid bonding techniques offer advantages in the assembly of IC die structures to other IC die structures or some other host structure, such as a package substrate structure, interposer structure, or the like. In accordance with embodiments herein, an IC die structure may include any monolithic integrated circuit device that provides electrical, compute, memory, or similar functionality. An IC die structure may itself comprise more than one monolithic integrated circuit device. For example, an IC die structure may comprise two vertically stacked IC dies or two coplanar IC dies. IC dies within an IC die structure may be directly bonded to each other or coupled through interconnect features. IC die structures in accordance with embodiments herein may be referred to as "chiplets," "chiplet dies," "dice," "tiles," or "chips," for example. While the terms chiplet and IC die or chip may be used interchangeably, a fully functional ASIC is typically considered an IC die or chip while a chiplet or tile would have more limited functionality, for example supplementing one or more other IC chiplets that are to be part of the same multi-chiplet device. A chiplet or tile may, for example, be a wireless radio circuit, microprocessor core, electronic memory circuit, floating point gate array (FPGA), power management and/or power supply circuit, or include a MEMS device.

In the context of hybrid bonding IC die structures, self-alignment assisted assembly (SA3) may facilitate greater die-to-wafer hybrid bonding (D2W HB) throughput by reducing the burden of fine alignment. In some exemplary SA3 processes, bonding regions are incorporated into "biphilic" or "heterogeneous" surface structures on either (or both) an IC die structure or (and) a host structure. Biphilic/heterogeneous surfaces have a high wettability contrast between their distinct regions. As described further herein, a high wettability contrast can be achieved by physical patterning (e.g., creating trenches around the bonding area to confine liquid via the canthotaxis effect), chemical patterning (e.g., depositing hydrophobic coatings to lower surface energy around the bonding area), or combinations of the two (e.g., creating trenches with hydrophobically coated sidewalls surrounding the bonding area).

Within a biphilic surface structure one region has high wettability relative to another region of low wettability. This wettability contrast can improve control of liquid droplet spreading such that a liquid droplet may be confined on a bonding site of either (or both) an IC die structure or (and) a host structure. Surface tension of the droplet acts to passively fine-align the IC die structure as the droplet evaporates, leaving the bonding regions in contact and ready for hybrid bonding. At room temperature, attractive surface forces between the dielectric regions on the IC die structure and a host structure may suffice to temporarily affix the two. A hybrid bond may be subsequently formed through application of pressure and/or elevated temperature to form and/or strengthen bonds between the metal features (e.g., metal pads) dispersed within surrounding dielectric material. Once bonded, the metal features form a composite metal feature that electrically interconnects an IC die structure and a host structure. In some embodiments, however, bonding may be dielectric-dielectric only or metal-metal only (e.g., for thermal applications or some RF applications).

With SA3, a bonder may pick and place an IC die structure upon a host structure in reliance on coarse alignment (e.g., ~ 25-50 um) alone, enabling fast assembly. When a liquid droplet is confined to a bonding region between the IC die structure and the host structure, capillary forces and liquid surface tension induce alignment with high positional accuracy (e.g., < 200 nm) due to the biphilic or transition structures on mating surfaces of the IC die structure and/or host structure. Such biphilic or heterogenous structures may therefore be more specifically referred to as "self-alignment features" or "SA3 features."

Prior to bonding, metallization features that are to be bonded may be exposed to oxidizing atmosphere, such as air or water droplets. This exposure can lead to surface oxidation, which could result in higher contact resistance and/or yield loss. Queue time between exposure to atmosphere and the bonding process may be controlled. However, in certain bonding processes (e.g., those leveraging SA3 technology) where metallization features may be exposed to water surface oxidation reactions may nevertheless occur to form a thickness of metal oxide that can reduce electrical performance of composite metallization features.

As described below, to enable superior performance during hybrid bonding of an IC die structure to a host structure, a surface finish may be formed on the IC die structure and/or host structure. As described further below, the surface finish may have a different chemical composition than the underlying metallization and thereby better resist oxidation prior to bonding. After bonding, the surface finish may be retained as a bond interfacial layer embedded between metallization features of the IC die structure and the host structure. Advantageously, the composition and/or thickness of the surface finish ensures a bond interface of sufficiently low electrical resistance. The electrical resistance attributable to a bond interface comprising one or more elements introduced by the surface finish is advantageously significantly lower than the electrical resistance that would otherwise be attributable to the presence of metal oxide at the bond interface.

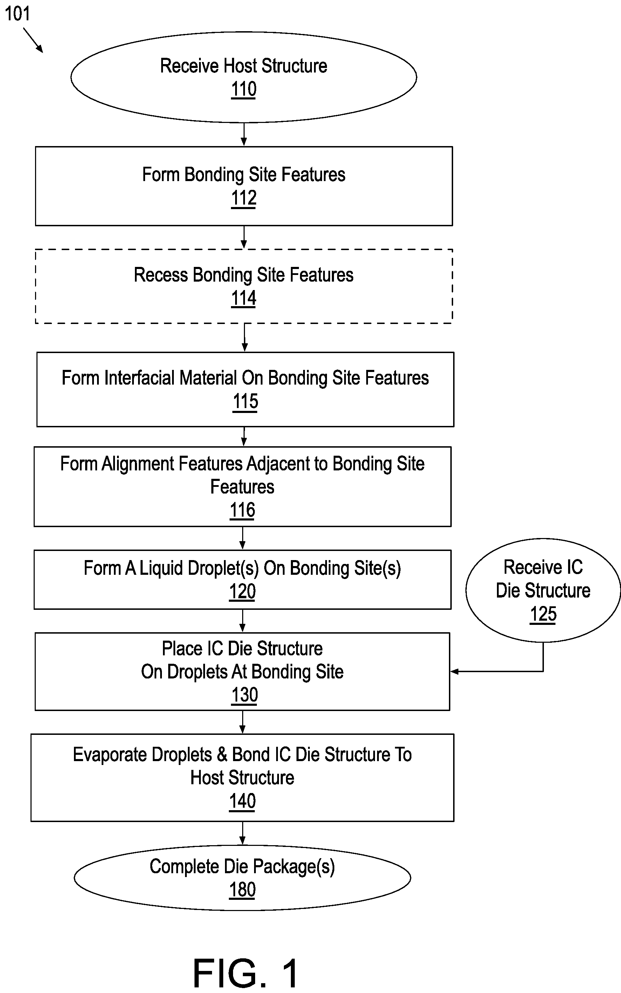

FIG. 1 is a flow diagram illustrating self-alignment assisted assembly methods 101 for integrated circuit (IC) die structures, in accordance with some embodiments. According to methods 101, IC die structures are assembled to a host structure by practicing one or more SA3 techniques. Prior to assembly, an IC die structure and/or a host structure are processed to form a surface finish on a top surface of metallization features that are to be bonded during assembly. Methods 101 may be practiced, for example, to form one or more of the composite assemblies described elsewhere herein. Methods 101 are illustrated as including several discrete blocks to ensure clarity of description. However, in practice the number of blocks, and/or order of such blocks, may be modified without departing from the principles illustrated by methods 101.

Methods 101 begin at input 110 where a first structure is received. The first structure may be a portion of any wafer, panel, or strip, etc. that is suitable for the formation of bonding site structures that are to be directly bonded, or otherwise interconnected, with one or more IC die structures. The bonding site features are formed within a bonding region or bonding site of the host structure. The bonding region is advantageously integrated into one or more biphilic surfaces that are suitable for SA3 assembly.

In some embodiments, the host structure received at input 110 is a "base" substrate structure, and an IC die structure that is to be assembled with the host substrate structure is received at input 125. In other embodiments, the host structure received at input 110 is an IC die structure and another IC die structure received at input 125 is assembled with the host IC die structure.

Methods 101 continue at block 112 where bonding site features are formed on the host structure. In some exemplary embodiments where the bonding site features comprise metallization, block 112 comprises a damascene metallization process suitable for either backend metallization levels of an IC die structure or metallization levels of a package substrate structure. The metallization process may for example, comprise the formation of trenches into a dielectric material, a filling of the trenches with metallization, and a planarization of the metallization that exposes the dielectric material surrounding metallized trenches. In some exemplary embodiments, the metallization formed at block 112 comprises copper (Cu). While Cu has excellent electrical conductivity, it is susceptible to forming oxides associated with different metal oxidation states (e.g., cuperous oxide, cupric oxide, etc.). Such oxides have significantly lower electrical conductivity and therefore would be disadvantageous to retain in an electrical device.

Planarization of the metallization at block 112 may result in some recess of one of the dielectric material or the metallization relative to the other. Such "dishing" may, for example, recess the metallization relative to a plane of the surrounding dielectric surface. Alternatively, the dielectric may be dished relative to a plane of the metallization. Despite such dishing, the metallization features are substantially co-planar with the surrounding dielectric.

Methods 101 continue at block 114 where metallization features are optionally recessed relative to surrounding dielectric material increasing non-planarity of the metallization features relative to the surrounding dielectric material. Block 114 is illustrated with a dashed line to emphasize it is optional. For example, planarization of the metallization at block 112 may induce enough dishing of metallization features that additional recessing at block 114 may be unnecessary.

At block 115, a surface finish is formed upon a surface the metallization features not protected by the surrounding dielectric material. In exemplary embodiments, formation of the surface finish comprises the deposition of a material having a different chemical composition than that of the metallization features. Deposition of the finish material may be selective to the metallization features, forming the surface finish only on the metallization features. The deposition may also be nonselective, forming a material layer over both the metallization features and the surrounding dielectric material. The metallization features may be augmented by the finish material deposited at block 115, becoming sufficiently co-planar with the surrounding dielectric to ensure success during a subsequent bonding process. In some embodiments, the finish material deposited at block 115 may be selectively removed from the dielectric material with a planarization process because of non-planarity between the metallization features and surrounding dielectric.

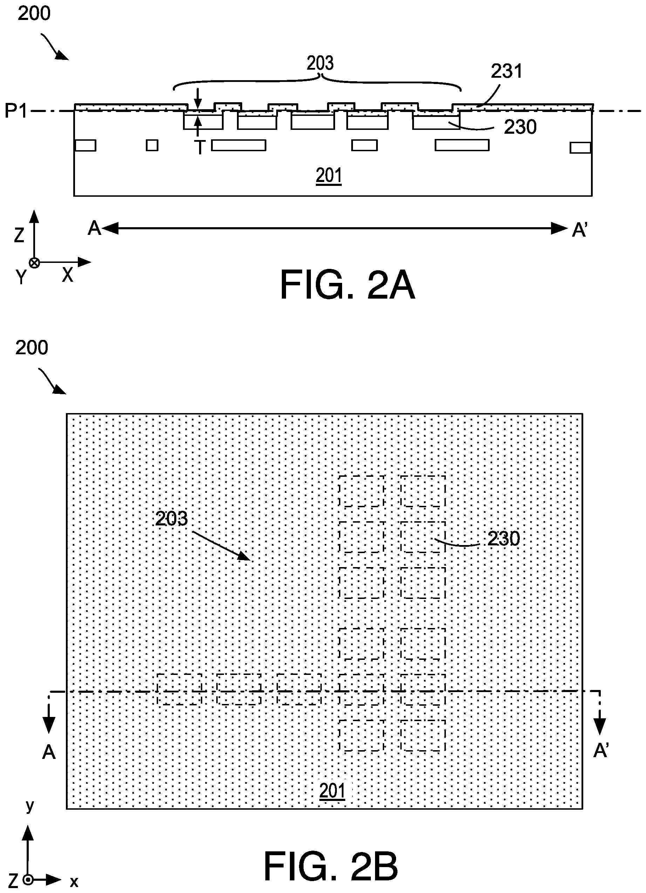

FIG. 2A is a cross-sectional view illustrating deposition of a finish material 231 upon a host structure 200, in accordance with some embodiments. FIG. 2B is a plan view of the host structure 200, in accordance with some further embodiments. The cross-sectional plane A-A' illustrated in FIG. 2A is demarked by a dot-dashed A-A' line in FIG. 2B.

Host structure 200 comprises one or more substrate materials 201. Substrate materials 201 may vary according to implementation. In some embodiments where host structure 200 is a package substrate structure, or package interposer structure, substrate materials 201 may include one or more structural material layers, such as semiconductor materials (e.g., monocrystalline), sapphire, or glass. Substrate materials 201 may include any of those found in an integrated circuit wafer, such as semiconductor materials (e.g., silicon, germanium, GaN, GaAs, InP, InGaAS, etc), on-die interconnect layers (e.g., copper, aluminum, tantalum, other metals), and on-die dielectrics (e.g., silicon dioxide, carbon-doped silicon dioxide, silicon nitride, silicon carbide, etc.). For glass embodiments, the structural material may be predominantly silica (e.g., silicon and oxygen) and may further include one or more elements such as hydrogen, carbon and/or metals, such as, but not limited to copper, silver, gold, aluminum, beryllium, magnesium, calcium, strontium barium, or radium. Additional dopants (e.g., boron, phosphorus) may also be present in the structural material (e.g., borosilicate glass, etc.).

Substrate materials 201 may also include one or more levels of metallization features 230. Metallization features 230 may be embedded, for example, within a dielectric material. The dielectric material may have been built up on one or more side of a structural material layer, for example. Structural material layers may be retained or ultimately discarded so that substrate materials 201 may comprise only dielectric material and embedded routing metallization features 230. Dielectric material may be an organic dielectric, such as, an epoxy resin, phenolic-glass, or a resinous film such as the GX-series films commercially available from Ajinomoto Fine-Techno Co., Inc.(ABF). Package dielectric material may comprise epoxy resins (e.g., an acrylate of novolac such as epoxy phenol novolacs (EPN) or epoxy cresol novolacs (ECN)). In other examples, package dielectric material includes aliphatic epoxy resin, which may be monofunctional (e.g., dodecanol glycidyl ether), difunctional (butanediol diglycidyl ether), or have higher functionality (e.g., trimethylolpropane triglycidyl ether).

Host structure 200 may also comprise an inorganic dielectric material (e.g., comprising at least 20 atomic % of one or more of silicon, oxygen, or nitrogen). In some embodiments, the inorganic dielectric material is primarily silicon and oxygen (e.g., SiO₂), primarily silicon and nitrogen (e.g., Si₃N₂), or primarily silicon, oxygen and nitrogen (e.g., SiₓO_{y}Nₓ). An inorganic dielectric material may further comprise one or more dopants, such as carbon. Inorganic dielectric materials are nevertheless distinct from organic dielectrics (e.g., epoxy resins and phenolic-glasses), which have much higher carbon content and a higher percentage of carbon-hydrogen bonds.

Substrate materials 201 may also include one or more IC die structures (not depicted). In some embodiments where host structure 200 is a package substrate or interposer, an IC die structure is embedded within dielectric material. In other embodiments, host structure 200 is an IC die structure. Such IC die structures may be fully functional ASICs, or may be chiplets or tiles of more limited functionality to supplement one or more other IC die structures that are to be part of the same multi-chip device. For embodiments where host structure 200 is an IC die structure, substrate materials 201 may include any of those materials typical of monolithically fabricated IC dies, such as, but not limited to, a device material layer and/or a silicon (e.g., monocrystalline) layer, inorganic dielectric materials (e.g., comprising at least 20 atomic % of one or more of silicon, oxygen, or nitrogen), and metallization features 230.

Metallization features 230 may comprise one or more metals or metal alloys. In some embodiments, metallization features 230 includes a barrier material (not depicted), which may line an interface with a surrounding dielectric material. The barrier material may be Ti, TiN, Ta, or TaN, for example. In some further embodiments, metallization features 230 comprise a fill metal over the barrier material. Exemplary fill metals comprise predominantly Cu.

As illustrated in FIG. 2A, a bonding site structure 203 comprises a plurality of metallization features 230 that are within an uppermost metallization level of host structure 200. Within bonding site structure 203, a top surface of metallization features 230 is recessed relative to a plane P1 corresponding to a top surface of surrounding dielectric material. As noted above, recession of metallization features 230 may be attributable to dishing during a planarization process or may be attributable to another selective metallization etch process. For example, in some embodiments where the fill metal is predominantly Cu, host structure 200 may be exposed to a wet chemical etchant capable of dissolving Cu (or its oxides). A dry etch (e.g., an atomic layer etch) may also be practiced in combination with, or in the alternative to, wet chemical etching.

A thickness of finish material 231 augments metallization features 230. In the example illustrated in FIG. 2A and 2B, finish material 231 has been formed over an entirety of host structure 200. Any deposition process suitable for the composition of material 231 and compatible with host structure 200 may be practiced. Surface finish material 231 has a different chemical composition than that of metallization features 230 and is to provide a surface finish on metallization features 230 that will inhibit oxidation.

In some embodiments, material 231 includes a metal substantially absent from metallization features 230, such as one or more of Ni, Mn, Pd, Ti, Pt, or Ru. In some advantageous embodiments, finish material 231 is Cu alloy comprising one or more of Ni or Mn, Pd, Ti, Pt, or Ru. For example, finish material 231 may be a Cu-Ni alloy, such as Constantan, which typically has a Ni content around 45 wt. %. In another example, surface finish material 231 is a Cu-Mn alloy, such as Manganin that further comprises Ni (e.g., ~12 wt. % Mn, and 2 wt. % Ni with the balance being Cu). Both Constantan and Manganin alloys are more resistance to oxidation than Cu compositions lacking these minority constituents. Notably, while electrical conductivity of these alloys is lower than that of purer Cu, the conductivity is significantly higher than that of copper oxides.

In other advantageous embodiments, surface finish material 231 is predominantly a noble metal, such as Pd, Pt, or Ru. Each of these metals are more resistant to oxidation than copper and have reasonably good electrical conductivity. Material 231 may also be predominantly any alternative metal, such as Ti, offering acceptable electrical performance and improved oxidation resistance.

Depending on the metal composition of material 231, the deposition process may be nonselective to metallization features 230 (as illustrated in FIG. 2A and FIG. 2B). For example, a substantially pure metal or metal alloy film may be sputter deposited over the entire working surface of host structure 200. For some metals, a selective deposition process, such as an autocatalytic deposition, may be employed to selectively deposit the surface finish. Autocatalytic depositions suitable for forming either Cu or Ni are commercially available and such processes may be suitable for selectively depositing one or more of the Cu-Ni alloy compositions described above. For such a deposition process, surface finish material 231 may only form on metallization features 230 because an autocatalytic deposition will deposit metal only upon a catalytic metal surface and not on a non-catalytic dielectric surface.

In some other embodiments, surface finish material 231 includes a non-metal, such as organic material, for example comprising at least ten atomic (at.) % carbon (C), and advantageously at least 30 at. % C, or more. In some embodiments, material 231 comprise a self-assembled monolayer (SAM) material such as an alkyl or fluoroalkyl silane (e.g., ODS, FDTS). SAM reactions typically form monolayer molecules aligned with each other in a uniform manner. Such a molecule may be introduced in the vapor phase and "self-assemble" by forming a highly selective bond at the surface of metallization features 230, and orientating itself perpendicular to the face of the surface. The bond of a SAM molecule may comprise Si, for example, such that material 231 is predominantly C and further comprises Si. For SAM-based materials, material 231 may be selectively formed on the exposed surface of metallization features 230 with substantially no deposition upon the surrounding dielectric material. Non-SAM based materials or films are also possible. In some embodiments, material 231 is, or includes, a substantially amorphous polymer thin film such as a siloxane (e.g., PDMS and derivatives, HMDSO), a silazane (HMDS) that lacks the molecular ordering of a SAM-based material. Such a material may be deposited in a non-selective manner so that the material 231 is formed over both metallization and dielectric of host structure 200, substantially as illustrated in FIG. 2A and 2B.

Although organic compositions may not offer high electrical conductivity, such compositions may be nevertheless suitable for material 231 if of a minimal as-deposited thickness T and/or material 231 becomes subsequently altered after a bonding process (e.g., partially decomposing and/or undergoing significant solid state diffusion). Generally, for any interfacial material layer, some diffusion into the metallization features 230 can be expected so that the as-deposited thickness T may decline with further processing of host structure 200. The as-deposited thickness T is advantageously minimized but sufficient to passivate metallization features 230 by inhibiting the formation of oxygen compounds (i.e., metal oxides). In some embodiments, material 231 is deposited to a thickness T of no more than 5 nm, and advantageously less than 3 nm (e.g., 1-2 nm).

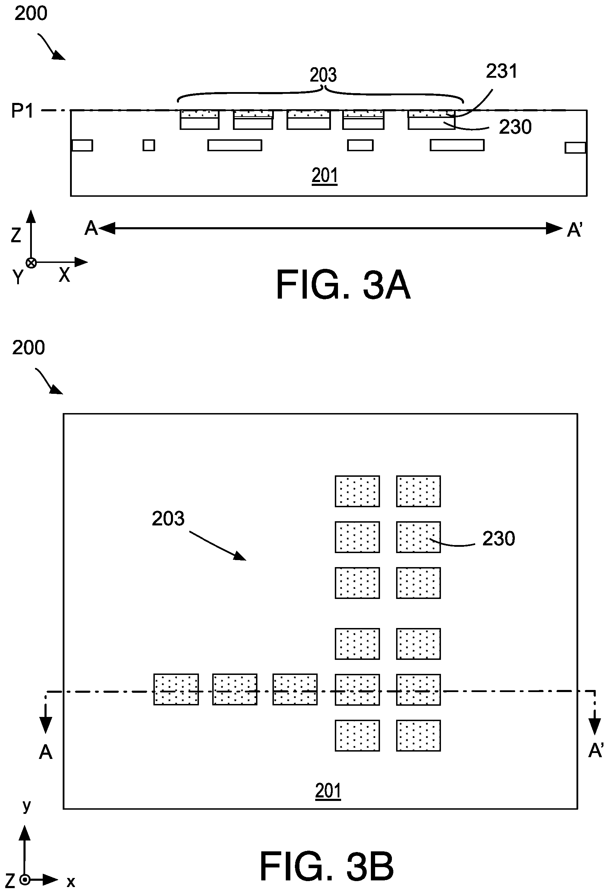

FIG. 3A is a cross-sectional view further illustrating host structure 200 to include surface finish material 231 only on metal bonding site features, in accordance with some embodiments. FIG. 3B is a plan view of the further illustrating host structure 200. FIG. 3A and FIG. 3B illustrate embodiments where a blanket-deposited material 231 (e.g., as illustrated in FIG. 2A) has been patterned or planarized. FIG. 3A and FIG. 3B also illustrate embodiments where material 231 is selectively deposited. For either embodiment, material 231 is retained only as a surface finish on metallization features 230. For embodiments where material 231 is deposited non-selectively, any material that extends above plane P1 of the surrounding dielectric material may be removed with a planarization process. Such a process may rely on prior recession of metallization features 230 to retain at least a portion of material 231 as a surface finish on metallization features 230. In other embodiments a masked etch may remove surface finish material from regions outside of metallization features 230. Regardless of the technique employed to pattern material 231, the patterning need only prevent electrical shorts between various ones of metallization features 230.

Methods 101 (FIG. 1) continue at block 116 with formation of alignment features, which are advantageously suitable for self-alignment assisted assembly (SA3). Such alignment features may be formed in a peripheral region adjacent to bonding sites. In exemplary embodiments, the alignment features are formed after the surface finish is applied to the bonding site features. However, in other embodiments the alignment features are formed prior to application of the surface finish. Alternatively, the alignment features may be formed concurrently with the bonding site features.

In some embodiments, at least a portion of the substrate materials are etched and/or recessed relative to the bonding site structure, for example to generate topography. Depending on the material or chemical composition(s) of the substrate materials, one or more etch processes may be employed at block 116. As noted above, a high wettability contrast can be achieved by physical patterning (e.g., creating trenches around the bonding area to confine liquid via the canthotaxis effect). Hence, forming a recess, or trench, at block 116 may be one element of fabricating SA3 alignment features.

The topographic features generated at block 116 may advantageously increase wettability contrast relative to a bonding region. Such topographic features (e.g., trenches) can change a liquid droplet's effective contact angle to greater than 90° and thereby alter the surface energy characteristics of the droplet. In some further embodiments, block 116 results in topographic features having significantly higher average surface roughness than in a bonding region. Block 116 may therefore comprise any surface texturing techniques, such as laser surface roughening.

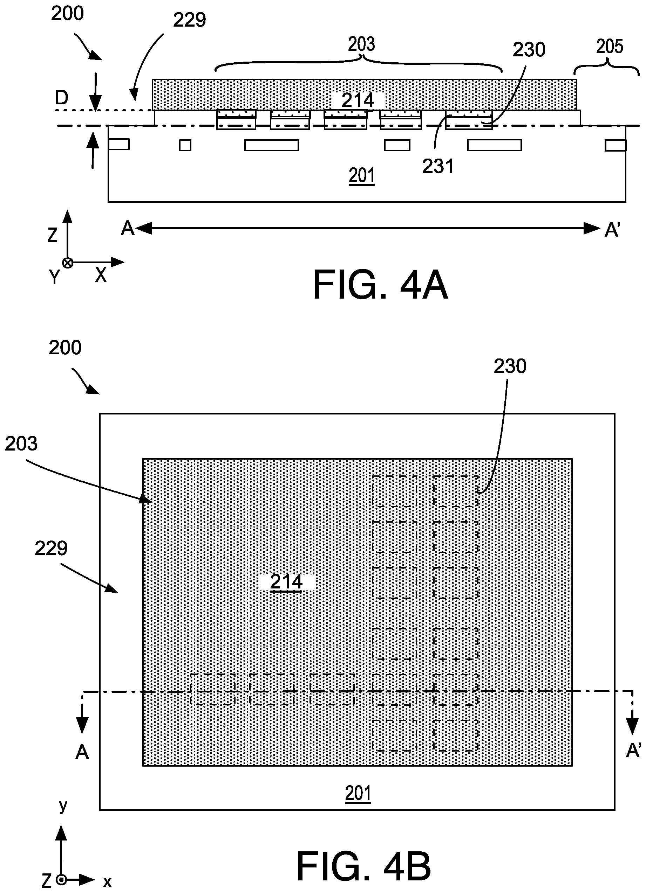

FIG. 4A is a cross-sectional view of alignment features defined into host structure 200, in accordance with some embodiments. FIG. 4B is a plan view of host structure 200, in accordance with some further embodiments. As shown in FIG. 4A, a trench 229 is etched into substrate materials 201 within a peripheral region 205 that is adjacent to bonding site structure 203. During alignment feature etching, bonding site structure 203 may be protected by one or more mask materials 214. Trench 229 may be formed to a depth D, which may vary with implementation (e.g., 10-50 nm, or more). As illustrated in FIG. 4B, trench 229 is continuous about a perimeter of bonding site structure 203. However, alternative embodiments may include a plurality of trenches 229 that are laterally adjacent to, or define, one or more edges of bonding site structure 203.

Surfaces of trench 229 may advantageously have a roughness greater than the surface roughness of an adjacent bonding region. For example, metallization features 230, as passivated by surface finish material 231, may have a lower surface roughness (e.g., <15 nm average roughness) while trench 229 has higher surface roughness (e.g., >50 nm average roughness). Dielectric material within bonding site structure 203 may also have lower roughness (e.g., <5 nm average roughness) than dielectric material surfaces of trench 229. In some embodiments, the average surface roughness of at least a bottom of trench 229 is at least twice the average surface roughness of surface finish material 231 and may be five, ten, or twenty times that of a metallization features 230. As used herein, average roughness (or center line average) is as described in ASME B46.1. Average roughness is the arithmetic average of the absolute values of profile height deviations from a mean line that is recorded for an evaluation length. Average roughness may be measured, for example, with a profilometer comprising a stylus that is traversed over a surface. For trench 229 having a longitudinal length in a first dimension (e.g., coincident with x-axis in FIG. 4B), average roughness may be measured over a distance roughly 60-70% of the longitudinal length while remaining at about a centerline of a transverse width of trench 229 that is in a dimension substantially orthogonal to the first dimension (e.g., coincident with x-axis).

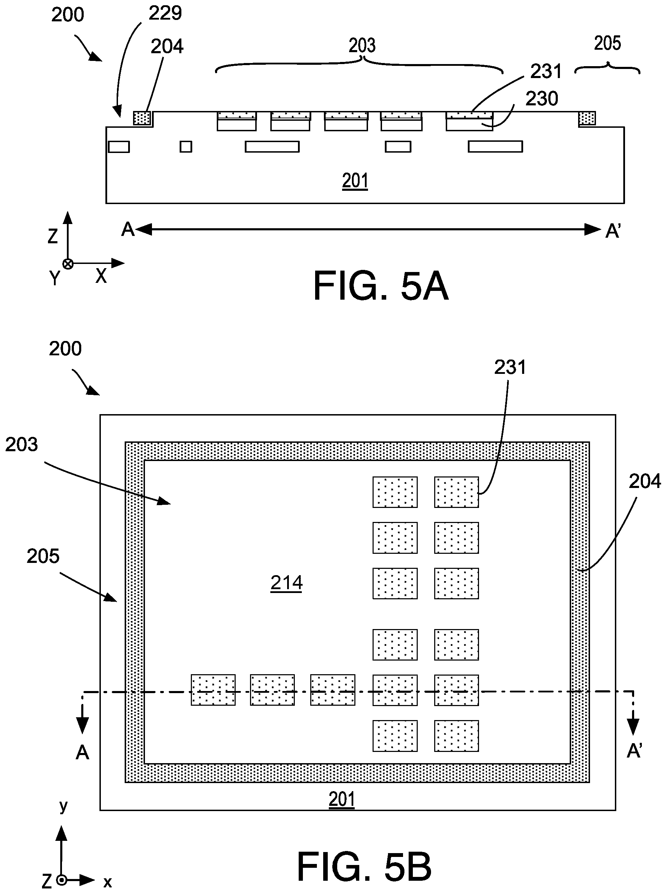

Hydrophobicity of the alignment features may be enhanced, for example through the formation of a hydrophobic material within a region at the periphery of a bonding region. FIG. 5A and FIG. 5B illustrate cross-sectional and plan views of hydrophobic features 204 formed within peripheral region 205, in accordance with some embodiments. Hydrophobic features 204 ensure host structure 200 has biphilic or transition structures with sufficient wettability contrast between bonding site structure 203 (e.g., of high wettability where a liquid droplet is to be formed), and the adjacent peripheral region 505 (e.g., of low wettability that will confine the liquid droplet). Although the liquid employed for self-alignment assisted assembly may vary (polar or non-polar, etc.), in exemplary SA3 embodiments employing water the bonding region of high wettability is hydrophilic (i.e., inducing a water droplet to have a contact angle of less than 90°). A water droplet will therefore tend to spread out over the bonding region as the liquid minimizes its surface energy. The peripheral region 205 of low wettability is hydrophobic (i.e., inducing a water droplet to have a large contact angle of greater than 90°). A water droplet on the bonding region will therefore tend to minimize contact with peripheral region 205.

Hydrophobic features 204 may comprise any chemical coating or thin film material and/or topographic structure that enhances a hydrophobic boundary adjacent to one or more edges of bonding site structure 203. In some embodiments, features 204 comprise a self-assembled monolayer (SAM) material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). Other SAM embodiments may comprise disulfides, amines, azoles, amides, imides, pyridine derivatives, cyanoacrylate derivatives or other moieties which include a sulfur atom or a nitrogen atom. SAM reactions typically form monolayer molecules aligned with each other in a uniform manner. Such a molecule may be introduced in the vapor phase and "self-assemble" by forming a highly selective bond at the surface and orientating itself perpendicular to the face of the surface. However, non-SAM based materials or films are also possible. In some embodiments, features 204 are, or include, a polymer thin film such as a siloxane (e.g., PDMS and derivatives, HMDSO), a silazane (HMDS), a polyolefin (e.g., PP), or a fluorinated polymer (e.g., PTFE, PFPE, PFDA, C₄F₈ plasma polymerized films, etc.). In some advantageous embodiments, features 204 have a chemical composition with at least ten atomic percent (at. %) carbon or at least ten at. % fluorine.

In the example illustrated, hydrophobic features 204 are in direct contact with a sidewall of trench 229 (or in direct contact with a barrier material lining trench 229). Features 204 may however be upon any other surface of trench 229. As shown in FIG. 5B, features 204 substantially surround a pedestal or mesa of substrate materials 201 that is bonding site structure 203. Features 204 maybe adjacent to multiple non-parallel edges of a bonding region and/or formed on sidewalls of bonding regions according to any suitable technique(s). A conformal hydrophobic material layer may be formed on exposed surfaces of bonding site structures, for example with either a spin coating or a conformal vapor deposition process. The conformal hydrophobic material layer may then be patterned with an anisotropic "spacer" etch.

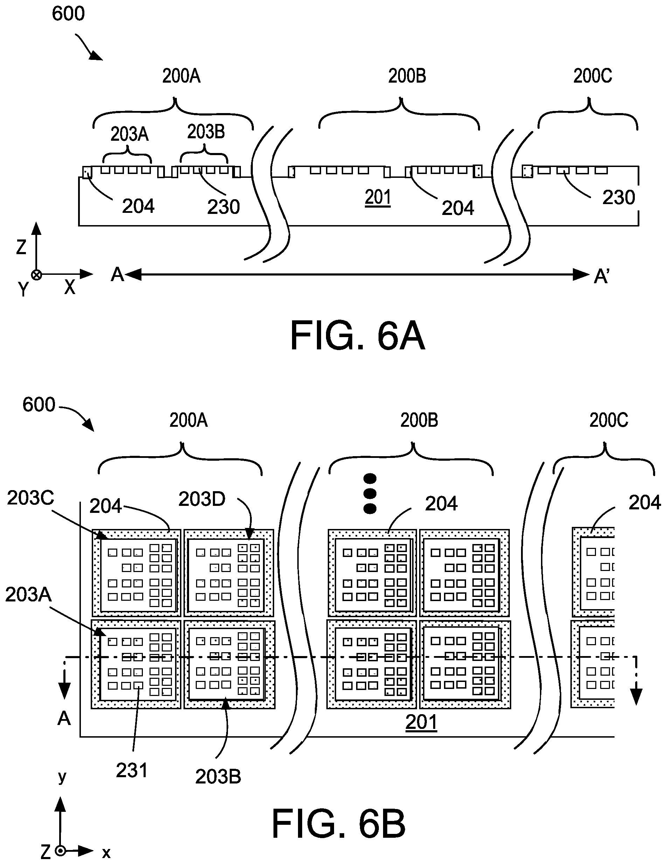

Host structure 200 may be part of a wafer or panel further comprising many such host structures. FIG. 6A is a cross-sectional view of an exemplary wafer (or panel) 600 comprising a plurality of aggregated host structures 200A, 200B, 200C. In the illustrated example, each host structure 200A-200C comprises a plurality of bonding site structures 203A and 203B on a first (e.g., top) side of one or more substrate materials 201. In some exemplary embodiments, each of bonding site structures 203A and 203B include substantially the same passivated metallization features described above for bonding site structure 203. FIG. 6B further illustrates a plan view of a portion of wafer (or panel) 600. As shown, four bonding regions comprising bonding site structures 203A, 203B, 203C and 203D are within separate quadrants of host structure 200A. Each of the bonding site structures is surrounded by a hydrophobic feature 204, which is within a trench (e.g., substantially as described above). In exemplary embodiments, one IC die is to be assembled upon each of the bonding site structures 203A-203D. However, in other embodiments as few as one IC die may be assembled on each of host structures 200A-200C.

Returning to FIG. 1, methods 101 continue at block 120 where a liquid droplet is formed on each bonding region of the host structure. Any techniques suitable for the liquid, such as vapor condensation or direct liquid dispense (i.e., printing) may be practiced at block 120 as embodiments are not limited in this respect. In some exemplary embodiments, a water droplet is dispensed at block 120. However, alternative polar (e.g., alcohols) or non-polar (e.g., solvents) liquids may be dispensed at block 120 depending on the nature of the host structure's wettability contrast.

A liquid droplet may be formed on the IC die structure (received at input 125) either in addition to the droplet formed on the bonding region at block 120, or as an alternative to the droplet formed at block 120. Methods 101 then continue at block 130 where the IC die structure received at input 125 is placed over a bonding region of the host structure prepared at block 120. The die structure received at input 125 may comprise a single IC die or may comprise any number of IC dies assembled (e.g., hybrid bonded) into a coplanar or 3D IC die structure. The IC die structure may, but need not, further comprise organic dielectric materials and/or metallization levels built up upon an IC die surface with a suitable semi-additive process (SAP). The IC die structure may further comprise metallization features comprising a surface finish substantially the same as that described above for the host structure. However, in other embodiments, metallization features of the IC die structure received at input 125 lack any surface finish.

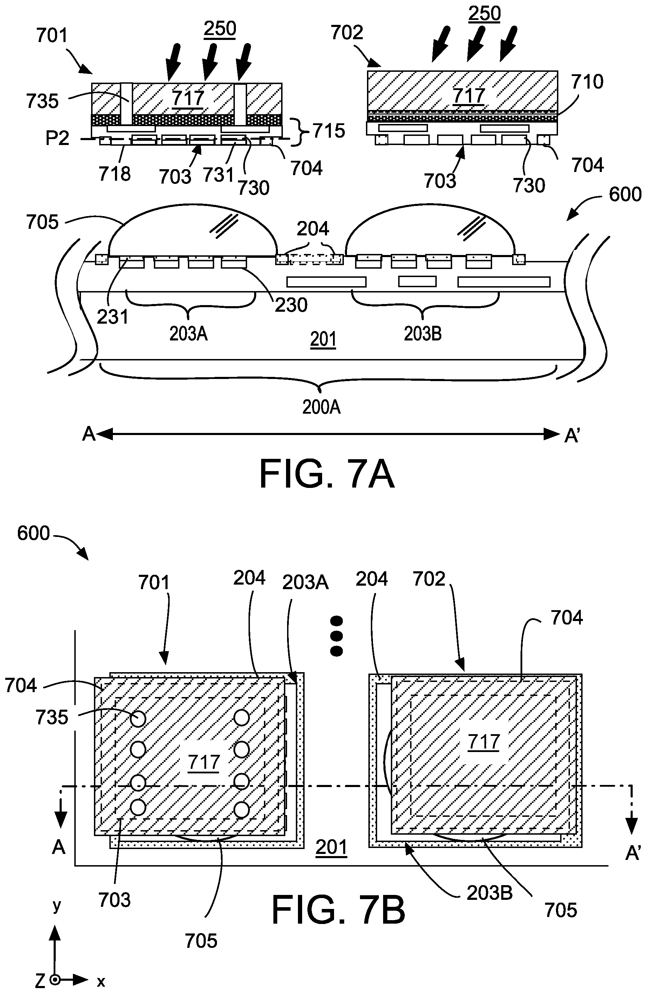

FIG. 7A is a cross-sectional view of IC die structures 701 and 702 undergoing an initial coarse alignment 250 to bonding site structures 203A and 203B. As so aligned, IC die structures 701 and 702 are placed upon liquid droplets 705 confined to bonding regions by the adjacent hydrophobic regions. Coarse alignment 250 may be performed, for example, with pick-and-place equipment. Such equipment may be capable of positional accuracy within 25-50 µm in each of the x-dimension and y-dimension, for example. FIG. 7B is a plan view of coarse alignment 250 and placement of IC die structures 701 and 702, in accordance with some embodiments. Some alignment error illustrated in FIG. 7B is to be corrected by liquid (e.g., water) droplet 705 during a passive fine alignment (e.g., via capillary forces, etc.) phase until the droplet evaporates. In exemplary embodiments, the fine alignment is advantageously to within 200 nm in each of the x-dimension and orthogonal y-dimension.

In the exemplary embodiments illustrated, IC die structures 701, 702 each comprise an IC die substrate material 717, a device layer 710 in contact with IC die substrate material 717, and IC die metallization levels 715 over device layer 710. IC die structures may include through substrate vias (TSVs) 735 extending from device layer 710 and into IC die substrate material 717. Although the chemical composition of IC die substrate material 717 may vary with implementation, in exemplary embodiments IC die substrate material 717 is a silicon (e.g., monocrystalline) layer. IC die substrate material 717 may also be of alternative compositions, such as, but not limited to, germanium (Ge), silicon germanium alloys (SiGe), gallium arsenide alloys (GaAs), indium phosphide alloys (InP), gallium nitride alloys (GaN), silicon carbide alloys (SiC), etc. Device layer 710 comprises active devices (not depicted). In some embodiments, the active devices within device layer 710 are field effect transistors (FETs). The FETs may be of any architecture (e.g., planar, non-planar, single-gate, multi-gate, stacked nanosheet, etc.) and may have a feature pitch of 10-30nm, for example. Additionally, or in the alternative, device layer 710 may include active devices other than FETs. For example, device layer 710 may include electronic memory structures, spin valves, or the like.

IC die structures 701, 702 comprise IC die metallization levels 715 on a front side of device layer 710. In exemplary embodiments, metallization levels 715 include die metallization features embedded within a dielectric material 718. Although IC die metallization features may have any composition(s) of sufficient electrical conductivity, in exemplary embodiments, IC die metallization features 730 are predominantly Cu. IC die structure 701 illustrates an example where metallization features 730 are passivated with surface finish material 731. Finish material 731 may have any of the compositions described elsewhere herein for surface finish material 231. In some exemplary embodiments finish material 731 has substantially the same composition as finish material 231. IC die structure 702 illustrates another example where metallization features 730 lack any passivating surface finish material.

In some advantageous embodiments, IC die structures 701, 702 comprise a biphilic surface structure corresponding to a complementary surface on host structure 200A comprising bonding site structures 203A, 203B. Metallization features 730 may have any pitch compatible with corresponding metallization features 230 within bonding site structures 203A and/or 203B. In some exemplary embodiments, individual metallization features 730 correspond to individual metallization features 230 and have a feature pitch in the range of 100 nm to 1 µm, for example. Metallization features 730 may have any suitable composition and may be of substantially the same composition as metallization features 230 (e.g., a same metallization) and may further include the same surface finish, or not. Metallization features 730 are embedded in a dielectric material 718, which may have any of the inorganic compositions described above for a host structure, for example. Metallization features 730 may be recessed below plane P2 for embodiments including surface finish material 731.

Within a periphery of bonding site structure 703, IC die structures 701, 702 may further comprise topographic alignment features, for example substantially as described above for host structure 200(A). As illustrated, IC die structures 701, 702 may have one or more trenches at the periphery of bonding site structure 703. IC die structures 701, 702 further comprise one or more hydrophobic features 704 adjacent to bonding site structure 703. Features 704 may have any of the properties or characteristics discussed elsewhere herein for features 204. The biphilic surface of host structure 200A and the biphilic surface of IC die structure 701 may therefore be substantially the same (as illustrated). IC die structure 702 may also be substantially the same except for lacking surface finish material 731.

As illustrated by dashed line in FIG. 7B, one or more hydrophobic features 704 substantially surround a perimeter of bonding site structure 703. Features 704 may be a single continuous material and/or structure with a hydrophobic surface. Alternatively, features 704 may comprise multiple discontinuous hydrophobic material segments delineating a perimeter about two or more edges of bonding site structure 703. Although FIG. 7A and FIG. 7B illustrate an example where two IC die structures 701, 702 are placed adjacent to one another upon one host structure 200A, one or more IC die structures may be placed upon a single host structure.

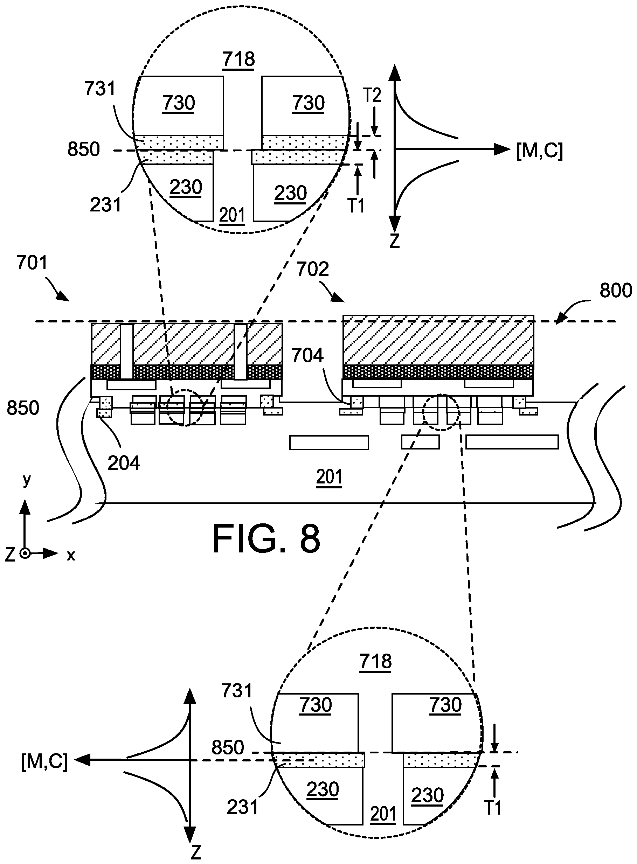

Returning to FIG. 1, methods 101 continue at block 140, where a liquid droplet between an IC die structure and host structure is evaporated, bringing metallization features of the IC die bonding site structure in direct contact with those of the host structure. The IC die structure may then be bonded to the host structure according to any suitable bonding technique(s), such as a hybrid bonding technique. FIG. 8 illustrates an exemplary hybrid bonded composite structure 800 where IC die structures 701, 702 are now in contact with host structure 200A along bond interface 850, denoted by a thick dashed line. Bond interface 850 comprises the surface finish of the metallization features on the IC die structure and/or the host structure, which has now become an interfacial material. Lateral offset between metallization features 230 and 730 is illustrated as being indicative of some non-zero misalignment that helps demark bond interface 850.

As shown in the expanded view of IC die structure 701, metallization features 230 are coupled with an overlapping portion of corresponding ones of metallization features 730 through bond interface 850 comprising both surface finish materials 231 and 731. For embodiments where materials 231 and 731 have substantially the same composition, the chemical composition of the composite metallization feature may be substantially symmetrical about bond interface 850. For example, a concentration of a metal M or carbon C, may monotonically decrease beyond thickness T1 as distance from bond interface 850 increases. The concentration function may also decrease monotonically beyond thickness T2 as distance from bond interface 850 increases.

Thicknesses T1 and T2 may, for example, sum to no more than 5nm and constituents of materials 231, 731 that are otherwise absent from metallization features 230 and 730 may diffuse into metallization features 230 and 730 some finite distance dependent upon thermal processing and diffusivity parameters of the mixtures. In some embodiments where surface finish materials 231 and 731 both comprise a Cu-Ni alloy, Ni content peaks proximal bond interface 850 (e.g., within T1 and T2). Ni content may decline (e.g., to less than 1 wt. % at a distance of no more than 5 nm from bond interface 850) in either z-axis direction (i.e., toward either of metallization features 230 or 730). In other embodiments where materials 231 and 731 both comprise an organic material, C content peaks proximal bond interface 850 and declines (e.g., or to less than 1 at. % at a distance no more than 5 nm from bond interface 850) in either z-axis direction (i.e., toward either of metallization features 230 or 730).

As further shown in the expanded view of IC die structure 702, metallization features 230 are coupled with an overlapping portion of corresponding ones of metallization features 730 through bond interface 850 comprising finish material 231. The chemical composition of the composite metallization feature may then be asymmetrical about bond interface 850 with a peak concentration of a constituent only found within thickness T1 of material 231 on the host structure side of bond interface 850. Content of metal M, or carbon C, may again monotonically decrease with greater distance from the peak concentration.

Dielectric material of host structure 200A is likewise in direct contact with dielectric material of IC die structures 701, 702. Individual ones of hydrophobic features 204 are similarly co-located with corresponding ones of features 704 on IC die structures 701, 702. Hydrophobic features 204 may also be in direct contact with hydrophobic features 704 along bonding interface 850, although they may not interdiffuse or meld to form a unified composite structure even after a thermos and/or compression bonding process. Features 204 may also be physically spaced apart from features 704 across bonding interface 850. As IC die structures 701, 702 are bonded along a substantially planar bonding interface 850, IC die backside surfaces may not be co-planar if there is a difference between die structure thicknesses.

Returning to FIG. 1, methods 101 end at output 180 where any processes may be practiced to complete packaging. For example, a fill material may be deposited over the bonded IC die structure, and over portions of the host structure that is not occluded by an IC die structure(s). The fill material is advantageously a dielectric material (e.g., an inorganic dielectric material or an organic dielectric material) such as any of those previously described. In exemplary embodiments the fill material is deposited to a thickness at least equal to the thickness of the IC die structure. The fill material may be deposited by any technique known to be suitable for the chosen composition and thickness of material. In some embodiments, a dielectric fill material may be applied with a spin-on or spray-on process and subsequently cured. In other embodiments, a dielectric fill material may be deposited with a chemical vapor deposition (CVD) process. In still other embodiments, a dielectric fill material may be deposited with a molding process. Depending on the deposition process, the dielectric fill material may be planar along a length spanning the IC die structure and extending beyond an edge of the IC die structure, or not. The fill material may be planarized, for example with a chemical mechanical planarization (CMP) system or any other suitable grinder and/or polisher.

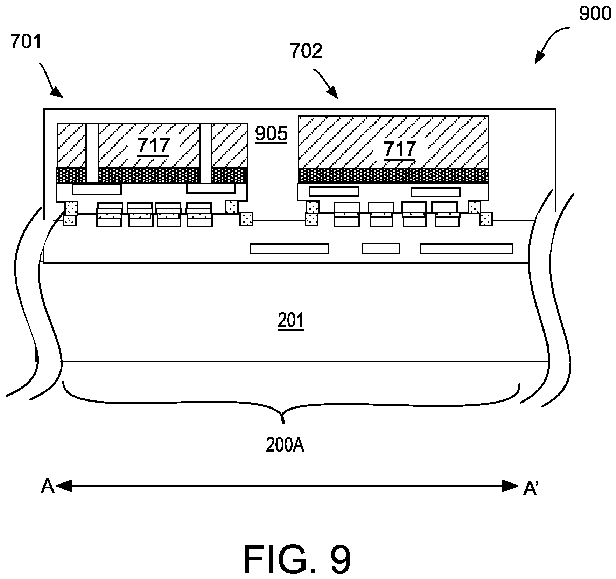

In the example illustrated in FIG. 9, composite structure 900 further includes a dielectric material 905 over IC die structures 701, 702. Dielectric material 905 also substantially backfills a gap between adjacent edge sidewalls of IC die structures 701, 702. In some embodiments, dielectric material 905 is one or more of any of the inorganic dielectric compositions previously described. In some other embodiments, dielectric material 905 is one or more of any of the organic dielectric compositions previously described. As illustrated, dielectric material 905 is substantially planarized across IC die structures 701, 702. Such planarization may be attributable to a dielectric deposition process and/or a post-deposition polishing or CMP process.

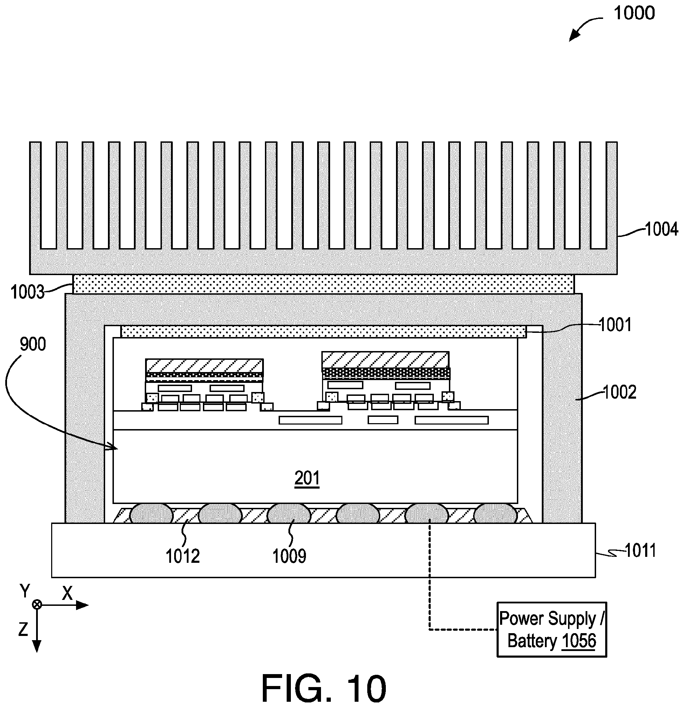

FIG. 10 is a cross-sectional view of system 1000 comprising a heat sink 1004 and a host component 1011 assembled with a hybrid bonded composite structure 900 further comprising an IC die structure and a host structure, at least one of which a surface finish on metallization features that is at the bond interface, for example in accordance with one or more embodiments described herein. System 1000 may include any number of composite structures 900 mounted to host 1011 by way of interconnects 1009, which are optionally embedded in an underfill material 1012. Host 1011 may be a cored or coreless package substrate, interposer, or board (such as a motherboard), for example.

System 1000 further includes a power supply 1056 coupled to one or more of host 1011 (i.e., a board, package substrate, or interposer), composite structure 900, and/or other components of system 1000. Power supply 1056 may include a battery, voltage converter, power supply circuitry, or the like. Microelectronic system 1000 further includes a thermal interface material (TIM) 1001 over composite structure 900. TIM 1001 may include any suitable thermal interface material. System 1000 further includes an integrated heat spreader (IHS) and/or lid 1002 in contact with TIM 1001 and extends over composite structure 900. System 1000 further includes another TIM 1003 in contact with a top surface of IHS 1002. TIM 1003 may include any suitable thermal interface material and may be of the same composition as TIM 1001, or not. System 1000 includes a heat sink 1004 (e.g., an exemplary heat dissipation device or thermal solution) in contact with TIM 1003. System 1000 may be further integrated into a computer, such as a mobile device or server, for example.

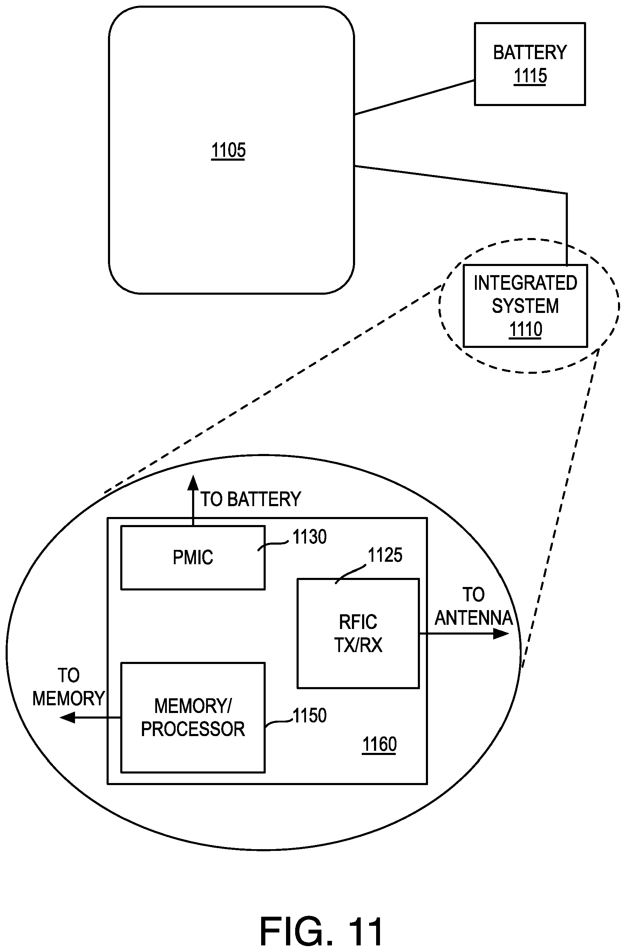

FIG. 11 illustrates an exemplary computer platform 1105 including a composite structure including a bonded IC die with biphilic surface structures proximal to a hybrid bond interface indicative of droplet-based fine alignment techniques. Platform 1105 may be a mobile computing platform and/or a data server machine, for example. A server machine may be any commercial server, for example, including any number of high-performance computing platforms disposed within a rack and networked together for electronic data processing. Platform 1105 may be any portable device configured for each of electronic data display, electronic data processing, wireless electronic data transmission, or the like. Platform 1105 may include a chip-level or package-level integrated system 1110, and a battery 1115. In some examples, the disclosed systems may be implemented in a disaggregated sub-system 1160.

Sub-system 1160 may include memory circuitry and/or processor circuitry 1150 (e.g., RAM, a microprocessor, a multi-core microprocessor, graphics processor, etc.), a power management integrated circuit (PMIC) 1130, and a radio frequency integrated circuit (RFIC) 1125 (e.g., including a wideband RF transmitter and/or receiver (TX/RX)). As shown, one or more IC dice, such as memory circuitry and/or processor circuitry 1150 may be co-packaged and/or co-assembled within a composite structure including an IC die having biphilic structures proximately to a hybrid bond interface, for example as described herein.

In some embodiments, RFIC 1125 includes a digital baseband and an analog front end module further comprising a power amplifier on a transmit path and a low noise amplifier on a receive path). Functionally, PMIC 1130 may perform battery power regulation, DC-to-DC conversion, etc., and so has an input coupled to battery 1115, and an output providing a current supply to other functional modules. As further illustrated in FIG. 11, in the exemplary embodiment, RFIC 1125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1150 may provide memory functionality, high level control, data processing and the like for sub-system 1160.

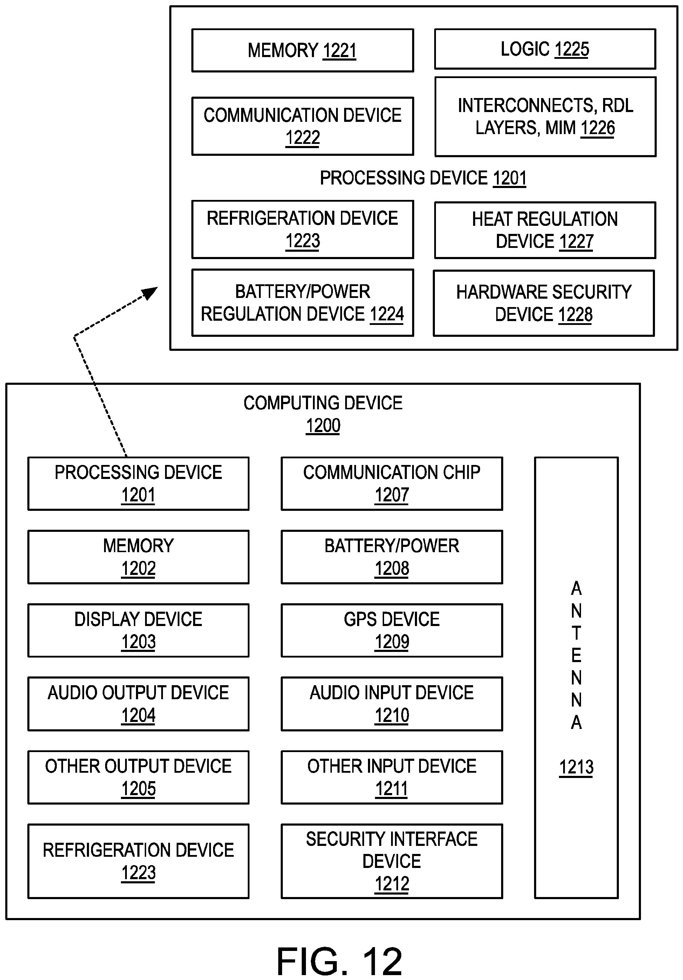

FIG. 12 is a block diagram of a cryogenically cooled computing device 1200 in accordance with some embodiments. For example, one or more components of computing device 1200 may include any of the devices or structures discussed elsewhere herein. A number of components are illustrated in FIG. 12 as included in computing device 1200, but any one or more of these components may be omitted or duplicated, as suitable for the application. In some embodiments, some of the components included in computing device 1200 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Additionally, in various embodiments, computing device 1200 may not include one or more of the components illustrated in FIG. 12, but computing device 1200 may include interface circuitry for coupling to the one or more components. For example, computing device 1200 may not include a display device 1203, but may include display device interface circuitry (e.g., a connector and driver circuitry) to which display device 1203 may be coupled.

Computing device 1200 may include a processing device 1201 (e.g., one or more processing devices). As used herein, the term processing device or processor indicates a device that processes electronic data from registers and/or memory to transform that electronic data into other electronic data that may be stored in registers and/or memory. Processing device 1201 may include a memory 1221, a communication device 1222, a refrigeration/active cooling device 1223, a battery/power regulation device 1224, logic 1225, interconnects 1226, a heat regulation device 1227, and a hardware security device 1228.

Processing device 1201 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1201 may include a memory 1202, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing 1201 shares a package with memory 1202. This memory may be used as cache memory and may include embedded dynamic random-access memory (eDRAM) or spin transfer torque magnetic random-access memory (STT-M RAM).

Computing device 1200 may include a heat regulation/refrigeration device 1223. Heat regulation/refrigeration device 1223 may maintain processing device 1201 (and/or other components of computing device 1200) at a predetermined low temperature during operation. This predetermined low temperature may be any temperature discussed elsewhere herein.

In some embodiments, computing device 1200 may include a communication chip 1207 (e.g., one or more communication chips). For example, the communication chip 1207 may be configured for managing wireless communications for the transfer of data to and from computing device 1200. The term "wireless" and its derivatives may be used to describe circuits, devices, systems, methods, techniques, communications channels, etc., that may communicate data through the use of modulated electromagnetic radiation through a nonsolid medium.

Communication chip 1207 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1207 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1207 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1207 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1207 may operate in accordance with other wireless protocols in other embodiments. Computing device 1200 may include an antenna 1213 to facilitate wireless communications and/or to receive other wireless communications (such as AM or FM radio transmissions).

In some embodiments, communication chip 1207 may manage wired communications, such as electrical, optical, or any other suitable communication protocols (e.g., the Ethernet). As noted above, communication chip 1207 may include multiple communication chips. For instance, a first communication chip 1207 may be dedicated to shorter-range wireless communications such as Wi-Fi or Bluetooth, and a second communication chip 1207 may be dedicated to longer-range wireless communications such as GPS, EDGE, GPRS, CDMA, WiMAX, LTE, EV-DO, or others. In some embodiments, a first communication chip 1207 may be dedicated to wireless communications, and a second communication chip 1207 may be dedicated to wired communications.

Computing device 1200 may include battery/power circuitry 1208. Battery/power circuitry 1208 may include one or more energy storage devices (e.g., batteries or capacitors) and/or circuitry for coupling components of computing device 1200 to an energy source separate from computing device 1200 (e.g., AC line power).

Computing device 1200 may include a display device 1203 (or corresponding interface circuitry, as discussed above). Display device 1203 may include any visual indicators, such as a heads-up display, a computer monitor, a projector, a touchscreen display, a liquid crystal display (LCD), a light-emitting diode display, or a flat panel display, for example.

Computing device 1200 may include an audio output device 1204 (or corresponding interface circuitry, as discussed above). Audio output device 1204 may include any device that generates an audible indicator, such as speakers, headsets, or earbuds, for example.

Computing device 1200 may include an audio input device 1210 (or corresponding interface circuitry, as discussed above). Audio input device 1210 may include any device that generates a signal representative of a sound, such as microphones, microphone arrays, or digital instruments (e.g., instruments having a musical instrument digital interface (MIDI) output).

Computing device 1200 may include a global positioning system (GPS) device 1209 (or corresponding interface circuitry, as discussed above). GPS device 1209 may be in communication with a satellite-based system and may receive a location of computing device 1200, as known in the art.

Computing device 1200 may include another output device 1205 (or corresponding interface circuitry, as discussed above). Examples include an audio codec, a video codec, a printer, a wired or wireless transmitter for providing information to other devices, or an additional storage device.

Computing device 1200 may include another input device 1211 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1200 may include a security interface device 1212. Security interface device 1212 may include any device that provides security measures for computing device 1200 such as intrusion detection, biometric validation, security encode or decode, managing access lists, malware detection, or spyware detection.

Computing device 1200, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

In first examples, an apparatus comprises a host structure comprising a plurality of metallization levels, an uppermost one of the metallization levels comprising one or more first metal features comprising predominantly Cu. The apparatus comprises an integrated circuit (IC) die structure coupled to the host structure, the IC die structure comprising a plurality of metallization levels, an uppermost one of the metallization levels comprising one or more second metal features comprising predominantly Cu, wherein the second metal features are in contact with corresponding ones of the first metal features along a bond interface, the bond interface comprising at least one of Ni, Mn, Pd, Ti, Pt, Ru, Si or C.

In second examples, for any of the first examples the bond interface comprises predominantly one of Pd, Ti, Pt, Ru, predominantly Si and C, or an alloy of Ni.

In third examples, for any of the second examples the bond interface has a thickness no greater than 5 nm, and wherein a concentration of the Ni, Mn, Pd, Ti, Pt, Ru, Si or C within the first metal features or second metal features beyond the bond interface is no more than 1 wt. %.

In fourth examples, for any of the third examples the bond interface has a thickness no greater than 2 nm.

In fifth examples, for any of the second examples the bond interface comprises Cu and Ni.

In sixth examples, for any of the fifth examples the bond interface comprises at least 40 wt. % Ni.

In seventh examples, for any of the fifth examples the bond interface comprises Cu, Ni, and Mn.

In eighth examples, for any of the seventh examples the bond interface comprises at least 10 wt. % Mn.

In ninth examples for any of the second examples the bond interface comprises predominantly one of Pd, Pt, or Ru.

In tenth examples, for any of the second examples the bond interface comprises predominantly Si and C.

In eleventh examples, an apparatus comprises a substrate structure comprising one or more first metal features within a first region of the substrate structure further comprising an inorganic dielectric material, wherein the first region is adjacent to a second region of the substrate. The apparatus comprises an integrated circuit (IC) die structure coupled to the substrate structure, wherein the IC die structure has a third region and an adjacent fourth region, the third region comprising an inorganic dielectric material and one or more second metal features. The second metal features are in contact with at least a portion of corresponding ones of the first metal features along a plane of a bond interface, the bond interface comprising Ni, Mn, Pd, Ti, Pt, Ru, Si or C. At least one of the second region or fourth region comprises an organic material having a composition of at least ten atomic percent carbon or at least ten atomic percent fluorine.

In twelfth examples, for any of the eleventh examples the first and second metal features comprise a fill metal comprising Cu and a barrier material between the fill metal and the inorganic dielectric material, and, within each of the first and second metal features, a concentration of the Ni, Mn, Pd, Ti, Pt, Ru, Si or C decreases with increasing distance from the bond interface.

In thirteenth examples, for any of the twelfth examples a concentration of the Ni, Mn, Pd, Ti, Pt, Ru, Si or C within the first metal features is no more than 1 wt. % at a distance of 5 nm from a corresponding one of the second metal features, and wherein a concentration of the Ni, Mn, Pd, Ti, Pt, Ru, Si or C within the second metal features is no more than 1 wt. % at a distance of 5 nm from a corresponding one of the first metal features.

In fourteenth examples, for any of the eleventh through thirteenth examples the inorganic dielectric material with the first region is substantially co-planar with the bond interface and wherein the inorganic dielectric material within the third region is substantially co-planar with the bond interface.

In fifteenth examples, for any of the eleventh through fourteenth examples, the apparatus comprises a host component interconnected to the substrate structure through solder features, the host component comprising a power supply route to couple the substrate structure to a power supply.

In sixteenth examples, a method comprises receiving a first of an integrated circuit (IC) die structure or a package substrate structure comprising a first region with first metallization features within first trenches in a dielectric material. The method comprises recessing the first metallization features below a plane of the dielectric material. The method comprises forming, over the first metallization features, a surface finish comprising Ni, Mn, Pd, Ti, Pt, Ru, Si or C. The method comprises bonding the first of the IC die structure or the package substrate structure with a second of the IC die structure or the package substrate structure, wherein the bonding comprises coupling the first metallization features to corresponding second metallization features through the surface finish.

In seventeenth examples, for any of the sixteenth examples forming the surface finish comprises depositing the surface finish over both the first metallization features and the dielectric material, and planarizing the surface finish to expose the dielectric material.

In eighteenth examples, for any of the sixteenth through seventeenth examples the first and second metallization features comprise predominantly Cu and wherein recessing the first metallization features comprises an atomic layer etch or wet chemical etch.

In nineteenth examples, for any of the sixteenth through eighteenth examples forming the surface finish comprises depositing a Ni-Cu alloy, or depositing at least one of Pd, Pt, or Ru.

In twentieth examples, for any of the sixteenth through nineteenth examples aligning the first of the integrated circuit (IC) die structure or the package substrate structure with the second of the integrated circuit (IC) die structure or the package substrate structure based on a wettability contrast between the first and second regions.

It will be recognized that principles of the disclosure are not limited to the embodiments so described, but instead can be practiced with modification and alteration without departing from the scope of the appended claims. The above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

## Claims

1. An apparatus, comprising:
a host structure comprising a plurality of metallization levels, an uppermost one of the metallization levels comprising one or more first metal features comprising predominantly Cu;
an integrated circuit (IC) die structure coupled to the host structure, the IC die structure comprising a plurality of metallization levels, an uppermost one of the metallization levels comprising one or more second metal features comprising predominantly Cu, wherein the second metal features are in direct contact with corresponding ones of the first metal features along a bond interface, the bond interface comprising at least one of Ni, Mn, Pd, Ti, Pt, Ru, Si or C.

2. The apparatus of claim 1, wherein the bond interface comprises predominantly one of Pd, Ti, Pt, Ru, predominantly Si and C, or an alloy of Ni.

3. The apparatus of claim 2, wherein the bond interface has a thickness no greater than 5 nm, and wherein a concentration of the Ni, Mn, Pd, Ti, Pt, Ru, Si or C within the first metal features or second metal features beyond the bond interface is no more than 1 wt. %.

4. The apparatus of claim 3, wherein the bond interface has a thickness no greater than 2 nm.

5. The apparatus of any one of claims 1-4, wherein the bond interface comprises Cu and Ni.

6. The apparatus of any one of claims 1-5, wherein the bond interface comprises at least 40 wt. % Ni.

7. The apparatus of any one of claims 1-6, wherein the bond interface comprises Cu, Ni, and Mn.

8. The apparatus of any one of claims 1-7, wherein the bond interface comprises at least 10 wt. % Mn.

9. The apparatus of any one of claims 1-8, wherein the bond interface comprises predominantly one of Pd, Pt, or Ru.

10. The apparatus of any one of claims 1-8, wherein the bond interface comprises predominantly Si and C.

11. The apparatus of any one of claims 1-10, wherein:
the one or more first metal features are within a first region of the host structure, the host structure further comprising an inorganic dielectric material, wherein the first region is adjacent to a second region of the host structure;
the IC die structure has a third region and an adjacent fourth region, the third region comprising an inorganic dielectric material and the one or more second metal features, wherein:
at least one of the second region or fourth region comprises an organic material having a composition of at least ten atomic percent carbon or at least ten atomic percent fluorine.

12. The apparatus of claim 11, wherein:
the first and second metal features comprise a fill metal comprising Cu and a barrier material between the fill metal and the inorganic dielectric material; and
within each of the first and second metal features, a concentration of the Ni, Mn, Pd, Ti, Pt, Ru, Si or C decreases with increasing distance from the bond interface.

13. The apparatus of claim 12, wherein a concentration of the Ni, Mn, Pd, Ti, Pt, Ru, Si or C within the first metal features is no more than 1 wt. % at a distance of 5 nm from a corresponding one of the second metal features, and wherein a concentration of the Ni, Mn, Pd, Ti, Pt, Ru, Si or C within the second metal features is no more than 1 wt. % at a distance of 5 nm from a corresponding one of the first metal features.

14. The apparatus of any one of claims 11-13, wherein the inorganic dielectric material with the first region is substantially co-planar with the bond interface and wherein the inorganic dielectric material within the third region is substantially co-planar with the bond interface.

15. The apparatus of any one of claims 11-14, further comprising a power supply route coupling the host structure to a power supply.
